# EUROPEAN PATENT APPLICATION

(11) **EP 2 078 741 A1**
(43) Date of publication of application: **15.07.2009**
(21) Application number: 07830767.5
(22) Date of filing: 29.10.2007
(51) Int. Cl.: C09J 7/02, H01L 21/304

(54) **THERMALLY STRIPPABLE DOUBLE FACED ADHESIVE SHEET AND METHOD OF WORKING WORK PIECE**

(30) Priority: 04.11.2006 JP 2006299737
(71) Applicant: Nitto Denko Corporation, Ibaraki-shi, Osaka 567-8680 (JP)
(72) Inventor: KIUCHI, Kazuyuki, Ibaraki-shi Osaka 5678680 (JP); YOSHIDA, Yoshinori, Ibaraki-shi Osaka 5678680 (JP)
(74) Representative: Grünecker, Kinkeldey, Stockmair & Schwanhäusser Anwaltssozietät
(86) International application number: PCT/JP2007/071033
(87) International publication number: WO 2008/053840

(57) **Abstract**

To provide a thermally strippable double faced adhesive sheet which, when one side of which is applied to the front side of a work piece and the other side is applied to a support as a hard substrate to carry out working on the back side of the work piece, does not suffer from the lifting of the support and the resulting cracking of the work piece during working even when the work piece has large surface roughness.

The thermally strippable double faced adhesive sheet comprising a substrate, a thermally strippable pressure-sensitive adhesive layer (A) arranged on one side of the substrate, and a pressure-sensitive adhesive layer (B) arranged on the other side of the substrate, in which the substrate comprises a porous substrate. The porous substrate preferably has a density of 0.9 g/cm³ or less and a tensile elastic modulus of 20 MPa or less. The substrate may comprise a laminate of the porous substrate and a non-porous substrate. Exemplary usable adhesives for the pressure-sensitive adhesive layer (B) include pressure-sensitive adhesives, ultraviolet-curable pressure-sensitive adhesives, thermally strippable pressure-sensitive adhesives, thermoplastic pressure-sensitive adhesives, and thermosetting pressure-sensitive adhesives.

## Description

### Technical Field

The present invention relates to a thermally strippable double faced adhesive sheet, and to a method of working a work piece using the thermally strippable double faced adhesive sheet. More specifically, it relates to a thermally strippable double faced adhesive sheet that can immediately reduce its adhesive strength through a heating treatment and is suitably used in the working of a work piece with large surface roughness, and to a method of working a work piece using the thermally strippable double faced adhesive sheet.

### Background Art

There have been known thermally strippable pressure-sensitive adhesive sheets which include a substrate and, arranged thereon, a pressure-sensitive adhesive layer containing heat-expandable microspheres (see, for example, Patent Documents 1 to 4). The thermally strippable pressure-sensitive adhesive sheets of this type can have reduced adhesive strength and be thereby easily peeled off from adherends by means of allowing the pressure-sensitive adhesive layer to foam or expand through heating. They are used typically for temporal fixation in manufacturing process of ceramic capacitors and grinding process of semiconductor wafers. In particular, with recent reduction in thickness of semiconductor wafers, there has been recognized a so-called "wafer support system" in which a wafer is laminated to a support having substantially the same size with the wafer through a thermally strippable double faced adhesive sheet so as to prevent, for example, the fracture of wafer during transportation.

[Patent Document 1] Japanese Examined Patent Application Publication (JP-B) No. S51-24534
[Patent Document 2] Japanese Unexamined Patent Application Publication (JP-A) No. S56-61468
[Patent Document 3] JP-A No. S56-61469
[Patent Document 4] JP-A No. S60-252681

### Disclosure of Invention

### Problems to be Solved by the Invention

Some of recent high-functional semiconductor wafers have, on their patterned surface, large projections represented by bumps and/or large depressions represented by transistors. A pressure-sensitive adhesive sheet, when applied to a semiconductor wafer of this type, follows the surface profile of the wafer, and consequently the backside of the sheet has a replica of the surface profile of wafer. In this case, when a support as the hard substrate is applied to the sheet, air bubbles are included between them or the support lifts in the periphery of the wafer. This causes problems such as entry of eater (water intrusion) and wafer cracking after the back grinding of wafer.

Accordingly, an object of the present invention is to provide a thermally strippable double faced adhesive sheet which, when one side of which is applied to the front side of a work piece and the other side is applied to a support as a hard substrate in order to carry out working on the back side of the work piece, does not suffer from the lifting of the support and resulting cracking of the work piece during working even when the work piece has large roughness (depressions and projections) on its surface. Another object of the present invention is to provide a method of working a work piece using the thermally strippable double faced adhesive sheet.

### Means for Solving the Problems

After intensive investigations to achieve the objects, the present inventors have found that a thermally strippable double faced adhesive sheet, even when laminated to a work piece with large surface roughness, can prevent the lifting of a support used as a hard substrate and the resulting cracking of the work piece during working by using a specific substrate as the substrate. The present invention has been made based on these findings.

Specifically, the present invention provides a thermally strippable double faced adhesive sheet comprising a substrate, a thermally strippable pressure-sensitive adhesive layer (A) arranged on one side of the substrate, and a pressure-sensitive adhesive layer (B) arranged on the other side of the substrate, in which the substrate comprises a porous substrate.

The porous substrate in the thermally strippable double faced adhesive sheet preferably has a density of 0.9 g/cm³ or less and a tensile elastic modulus of 20 MPa or less. The substrate may be comprised of a laminate of the porous substrate and a non-porous substrate. Exemplary usable adhesives for constituting the pressure-sensitive adhesive layer (B) include pressure-sensitive adhesives, ultraviolet-curable pressure-sensitive adhesives, thermally strippable pressure-sensitive adhesives, thermoplastic pressure-sensitive adhesives, and thermosetting pressure-sensitive adhesives.

The present invention further provides a method of working a work piece, the method comprising the steps of: applying a work piece and a support to one and to the other, respectively, of the thermally strippable pressure-sensitive adhesive layer (A) and the pressure-sensitive adhesive layer (B) of the thermally strippable double faced adhesive sheet; working the applied work piece; and recovering the worked work piece by peeling through a heating treatment.

Exemplary work pieces for use in the working method include electronic components and semiconductor wafers. This method is particularly advantageously applied to the working of a work piece in which the work piece has a side (surface) with a maximum surface roughness amplitude of 10 µm or more, the side of the work piece is applied to an adhesive face of the thermally strippable double faced adhesive sheet, and the applied work piece is worked. Advantages

The thermally strippable double faced adhesive sheet according to the present invention uses a porous substrate as its substrate, is thereby capable of satisfactorily absorbing roughness, and, even when applied to a work piece with large surface roughness, such as a bumped wafer, enables working (e.g., thin grinding) the work piece according to the wafer support system using a support.

### Brief Description of Drawings

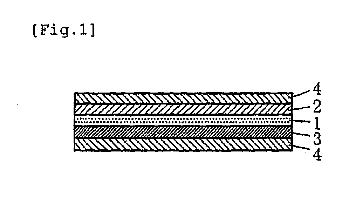

[Fig. 1] Fig. 1 is a schematic cross-sectional view showing a thermally strippable double faced adhesive sheet as an embodiment of the present invention.

### Reference Numerals

- 1: substrate
- 2: thermally strippable pressure-sensitive adhesive layer
- 3: pressure-sensitive adhesive layer
- 4: separator

### Best Modes for Carrying Out the Invention

The present invention will be illustrated in detail with reference the attached drawing according to necessity. Fig. 1 is a schematic cross-sectional view of a thermally strippable double faced adhesive sheet as an embodiment of the present invention. The adhesive sheet according to this embodiment includes a substrate 1; a thermally strippable pressure-sensitive adhesive layer 2 arranged on one side of the substrate 1; a pressure-sensitive adhesive layer 3 arranged on the other side of the substrate 1; and separators 4 respectively arranged on the thermally strippable pressure-sensitive adhesive layer 2 and on the pressure-sensitive adhesive layer.

The substrate 1 comprises a porous substrate and works as a base material for the thermally strippable pressure-sensitive adhesive layer 2 and the pressure-sensitive adhesive layer 3. The substrate 1 may comprise a porous substrate alone or comprise a laminate of a porous substrate and a non-porous substrate. The thermally strippable pressure-sensitive adhesive sheet according to the present invention uses at least a porous substrate as the substrate, and thereby, even when applied to a work piece with large surface roughness, absorbs the volume corresponding to the surface roughness. Thus, the replica corresponding to the roughness does not appear on the back side of the pressure-sensitive adhesive sheet. Accordingly, the thermally strippable pressure-sensitive adhesive sheet, when the back side of which is applied to a support according to the wafer support system, does not suffer from the inclusion of air bubbles and the lifting of the support, and this prevents water intrusion and wafer cracking after the back grinding of wafer.

Materials for the substrate 1 can be suitably selected within ranges not adversely affecting, for example, handleability as a pressure-sensitive adhesive sheet and include thermoplastic resins, thermosetting resins, elastomers, and any other materials. Exemplary materials include plastic films or sheets made typically of olefinic resins such as polyethylenes and polypropylenes; polyester resins such as poly(ethylene terephthalate)s and poly(ethylene naphthalate)s; polystyrenic resins such as polystyrenes; vinyl resins such as poly(vinyl chloride)s; polyurethane resins; acrylic resins such as poly(methyl methacrylate)s; acrylic-urethane copolymers; cellulosic resins; polycarbonate resins; polyamide resins; polyimide resins; polyamide-imide resins; polysulfone resins; fluorocarbon resins; and rubber polymers.

The porous substrate may be one formed according to any procedure. Exemplary usable porous substrates comprise a porous film prepared by flow casting a polymer solution into a film, and introducing the cast film in a coagulation bath; a porous film prepared through drawing; a porous film prepared by incorporating fine particles to be removed into a film, and removing the fine particles from the film typically through solving out; a porous film prepared by embossing a film; a porous film prepared by fusing a polymer powder with heating; a cellular film prepared by allowing a film to expand using a chemical blowing agent or physical blowing agent; and a film containing, as dispersed therein, hollow fillers such as heat-expandable microspheres or hollow glass beads. The average particle diameter of the hollow glass beads can be suitably set in consideration typically of the thickness of the porous substrate, but is generally from 3 to 200 µm and preferably from 10 to 100 µm. The average particle diameter of the heat-expandable microspheres can be also suitably set in consideration typically of the thickness of the porous substrate, but the average particle diameter after thermal expansion is, for example, from 3 to 100 µm, and preferably from 10 to 100 µm.

Preferred exemplary porous substrates include a sheet-like article prepared by applying a mixture containing a urethane polymer, an acrylic monomer, a photoinitiator, and hollow glass beads or heat-expandable microspheres typically to a non-porous substrate to form a film, and applying an ultraviolet ray thereto.

The density of the porous substrate is not particularly limited, but is usually about 0.9 g/cm³ or less (for example, from about 0.2 to about 0.9 g/cm³), and preferably from about 0.25 to about 0.7 g/cm³. The density herein is determined by measuring the size (length and width), thickness, and weight (mass) of a sample with a steel rule, a 1/1000-mm dial gauge (a dial gauge having a resolution of 1/1000 mm), and a 1/1000-g digital gravimeter in an atmosphere at room temperature (23°C) and humidity of 50%; and determining the density by dividing the weight by the volume (weight measuring method). A porous substrate, if having a density of more than 0.9 g/cm³, may not sufficiently work to absorb the roughness, and the adhesive sheet may fail to hold the adherend.

The tensile elastic modulus of the porous substrate is not particularly limited, but is usually about 20 MPa or less (for example, from about 0.1 to about 20 MPa), and preferably from about 0.1 to about 15 MPa. The tensile elastic modulus is determined by plotting a stress-strain curve using a tensile load measuring device, and reading the tensile elastic modulus as initial elastic modulus from the curve. A porous substrate, if having a tensile elastic modulus of more than 20 MPa, may not sufficiently work to absorb the roughness, and the adhesive sheet may fail to hold the adherend.

The thickness of the porous substrate is not particularly limited, but is usually from about 10 to about 1000 µm, preferably from about 25 to about 500 µm, and more preferably from about 50 to about 300 µm, from the viewpoint that the resulting porous substrate can be cut satisfactorily and sufficiently absorb the roughness. A porous substrate, if having a thickness of smaller than 10 µm, may often insufficiently absorb the roughness, and in contrast, a porous substrate, if having a thickness of larger than 1000 µm, may be often cut unsatisfactorily. When the substrate 1 is comprised of a laminate of a porous substrate and a non-porous substrate (such as a non-porous substrate made typically of a poly(ethylene terephthalate) or polyimide), the total thickness of the substrate is, for example, from about 20 to about 1100 µm, preferably from about 35 to about 550 µm, and more preferably from about 60 to about 350 µm.

When the substrate 1 is comprised of a laminate of a porous substrate and a non-porous substrate, the laminate can be prepared according to a common film lamination technique such as coating, extrusion, or dry lamination.

The thermally strippable pressure-sensitive adhesive layer 2 is a layer which, for example, expands or foams through heating so as to have a reduced bond strength to an adherend (work piece) and to peeled off from the adherend satisfactorily. The thermally strippable pressure-sensitive adhesive layer 2 usually includes a binder and a blowing agent such as heat-expandable microspheres. Exemplary suitably usable binders include polymers and waxes which allow the blowing agent, such as heat-expandable microspheres, to foam and/or expand through heating. Among them, preferred are those that confine, as less as possible, the foaming and/or expansion of the blowing agent such as heat-expandable microspheres. Of such binders, particularly preferred are pressure-sensitive adhesives, because the thermal expandability of the blowing agent (such as heat-expandable microspheres) and adhesive properties such as bond strength to the adherend can be satisfactorily controlled.

The pressure-sensitive adhesives are not particularly limited, and exemplary usable pressure-sensitive adhesives include pressure-sensitive adhesives made from polymers such as rubber polymers, acrylic polymers, vinyl alkyl ether polymers, silicone polymers, polyesters, polyamides, urethane polymers, fluorocarbon polymers, styrene-diene block copolymers; pressure-sensitive adhesives prepared by incorporating hot-melt resins with a melting point of about 200°C or lower into these materials to have improved creep properties; radiation-curable pressure-sensitive adhesives; and pressure-sensitive adhesives composed of, in addition to these materials, various additives including crosslinking agents such as polyisocyanates, alkyl-etherified melamine compounds, and epoxy compounds; tackifiers such as rosin derivative resins, polyterpene resins, petroleum resins, and oil-soluble phenol resins; plasticizers; softeners; fillers; pigments; colorants; age inhibitors; and surfactant (see, for example, JP-A No. S56-61468, JP-A No. S61-174857, JP-A No. S63-17981, and JP-A No. S56-13040). Each of different pressure-sensitive adhesives can be used alone or in combination

The pressure-sensitive adhesive constituting the thermally strippable pressure-sensitive adhesive layer 2 preferably contains, as a base polymer, a polymer having a dynamic elastic modulus of 5x 10⁴ to 1000x 10⁴ dyn/cm² at temperatures from room temperature to 150°C, because a pressure-sensitive adhesive of this type has a suitably controlled bond strength to the adherend before heating and also exhibits a satisfactorily reduced bond strength after heating.

Exemplary materials generally used as the pressure-sensitive adhesive include rubber pressure-sensitive adhesives containing, as base polymers, natural rubbers and various synthetic rubbers; and acrylic pressure-sensitive adhesives containing, as base polymers, acrylic polymers (homopolymers or copolymers) using, as monomer components, one or more of alkyl esters of (meth)acrylic acids. Exemplary alkyl esters include (C₁-C₂₀) alkyl esters such as methyl ester, ethyl ester, propyl ester, isopropyl ester, butyl ester, 2-ethylhexyl ester, isooctyl ester, isononyl ester, isodecyl ester, dodecyl ester, tridecyl ester, pentadecyl ester, hexadecyl ester, heptadecyl ester, octadecyl ester, nonadecyl ester, and eicosyl ester.

Where necessary, the acrylic polymer may further contain units corresponding to one or more other monomer components that are copolymerizable with the (meth)acrylic acid alkyl ester(s), so as to improve or modify properties such as cohesive strength, thermal stability, and crosslinkability. Exemplary copolymerizable monomer components include carboxyl-containing monomers such as acrylic acid, methacrylic acid, and itaconic acid; acid anhydride monomers such as maleic anhydride; hydroxyl-containing monomers such as hydroxyethyl (meth)acrylates and hydroxypropyl (meth)acrylates; sulfonic-containing monomers such as styrenesulfonic acid and allylsulfonic acid; amido-containing monomers such as N-methylol(meth)acrylamides; aminoalkyl (meth)acrylate monomers such as aminoethyl (meth)acrylates; alkoxyalkyl (meth)acrylate monomers such as methoxyethyl (meth)acrylates; maleimide monomers such as N-cyclohexylmaleimide; itaconimide monomers such as N-methylitaconimide; succinimide monomers such as N-(meth)acryloyloxymethylenesuccinimide; vinyl monomers such as vinyl acetate, vinyl propionate, vinylpyridine, and styrene; cyano acrylate monomers such as acrylonitrile and methacrylonitrile; epoxy-containing acrylic monomers such as glycidyl (meth)acrylates; glycolic acrylic ester monomers such as polyethylene glycol (meth)acrylates; acrylic ester monomers having, for example, a heterocycle, halogen atom, or silicon atom, such as tetrahydrofurfuryl (meth)acrylates, fluorine-containing (meth)acrylates, and silicone (meth)acrylates; multifunctional monomers such as hexanediol di(meth)acrylates, neopentyl glycol di(meth)acrylates, pentaerythritol di(meth)acrylates, trimethylolpropane tri(meth)acrylates, polyester acrylates, and urethane acrylates; olefinic monomers such as isoprene, butadiene, and isobutylene; and vinyl ether monomers such as vinyl ether. Each of different monomer components can be used alone or in combination.

Exemplary heat-expandable microspheres include microspheres composed of an elastic shell and, encapsulated therein, a material that can easily gasify and expand through heating, such as isobutane, propane, or pentane. The shell is often composed of a thermally fusible material or a material that breaks as a result of thermal expansion. Exemplary materials for constituting the shell include vinylidene chloride-acrylonitrile copolymers, poly(vinyl alcohol)s, poly(vinyl butyral)s, poly(methyl methacrylate)s, polyacrylonitriles, poly(vinylidene chloride)s, and polysulfones. The heat-expandable microspheres can be prepared according to a common procedure such as coacervation process or interfacial polymerization. Such heat-expandable microspheres further can also be commercially available products typically under the trade name "Matsumoto Microsphere" [from Matsumoto Yushi-Seiyaku Co., Ltd.].

Use of heat-expandable microspheres helps to stably protect the adherend from contamination due to heating. A naked blowing agent not microencapsulated, if used, may not sufficiently effectively protect the adherend from contamination, probably because of the cohesive failure of the pressure-sensitive adhesive layer. The heat-expandable microspheres for use herein preferably have such a suitable strength that does not burst until the rate of cubic expansion reaches 5 times or more, preferably 7 times or more, and particularly preferably 10 times or more.

The average particle diameter of the heat-expandable microspheres can be suitably set according typically to the thickness of the thermally strippable pressure-sensitive adhesive layer 2 and is, but not limited to, usually 100 µm or less (for example from 1 to 100 µm), preferably 80 µm or less (for example from 1 to 80 µm), and more preferably from 1 to 50 µm.

The amount of the blowing agent such as heat-expandable microspheres may be suitably set according typically to the expansion ratio of the thermally strippable pressure-sensitive adhesive layer 2 and on how the bond strength decreases. When the binder is, for example, a pressure-sensitive adhesive, the amount of the blowing agent is generally from 1 to 150 parts by weight, preferably from 10 to 130 parts by weight, and more preferably from 25 to 100 parts by weight, per 100 parts by weight of the base polymer of the binder.

The thickness of the thermally strippable pressure-sensitive adhesive layer 2 can be suitably set in consideration typically of the adhesion of the thermally strippable pressure-sensitive adhesive layer 2 and how its bond strength decreases upon peeling through heating. The thickness is generally 300 µm or less (for example from 1 to 300 µm), preferably from 2 to 200 µm, and more preferably from 5 to 150 µm. A thermally strippable pressure-sensitive adhesive layer, if having an excessively small thickness, may not exhibit a sufficient bond strength because it has a surface roughened due to the blowing agent such as heat-expandable microspheres. In contrast, a thermally strippable pressure-sensitive adhesive layer, if having an excessively large thickness, may not sufficiently deform through heating and may show not sufficiently reduced bond strength, from which the adherend may not be smoothly peeled.

The thermally strippable pressure-sensitive adhesive layer 2 can be formed, for example, by a process of mixing components such as a blowing agent (e.g., heat-expandable microspheres) and a binder where necessary with a solvent and spreading the mixture through a suitable procedure such as coating to form a sheet-like layer. The mixture may be directly spread over the substrate 1 typically by coating. Alternatively, it is also acceptable that the mixture is spread over a suitable separator (such as release paper) typically by coating to form a thermally strippable pressure-sensitive adhesive layer, and this layer is transferred onto the substrate 1.

The pressure-sensitive adhesive layer 3 is not particularly limited and may be composed of any known pressure-sensitive adhesive. Examples thereof include rubber, acrylic, and other pressure-sensitive adhesives, ultraviolet-curable pressure-sensitive adhesives, thermally strippable pressure-sensitive adhesives, thermoplastic pressure-sensitive adhesives, and thermosetting pressure-sensitive adhesives. The rubber and acrylic pressure-sensitive adhesives can be those listed above as rubber pressure-sensitive adhesives and acrylic pressure-sensitive adhesives. The pressure-sensitive adhesives may further contain additives of every kind. Exemplary additives include crosslinking agents such as polyisocyanates, alkyl-etherified melamine compounds, and epoxy compounds; tackifiers such as rosin derivative resins, polyterpene resins, petroleum resins, and oil-soluble phenol resins; plasticizers; softeners; fillers; pigments; colorants; age inhibitors; and surfactants.

When the substrate 1 is included of a laminate of a porous substrate and a non-porous substrate, the pressure-sensitive adhesive layer 3 may be arranged either on the porous substrate or on the non-porous substrate.

The thickness of the pressure-sensitive adhesive layer 3 is not particularly limited, but is generally from 0.1 to 500 µm, preferably from 1 to 300 µm, and more preferably from 5 to 250 µm, from the viewpoints the sheet can be satisfactorily cut and, after working, satisfactorily peeled off.

The thermally strippable double faced adhesive sheet according to the present invention can have a suitable form such as a sheet, tape, or label. The thermally strippable double faced adhesive sheet, in this case, can further include a separator 4 temporarily fixed to the thermally strippable pressure-sensitive adhesive layer 2 and/or the pressure-sensitive adhesive layer 3 so as to protect them. The separator 4 can be, for example, a plastic film or paper bearing a suitable release agent such as a silicone, long-chain alkyl, or fluorine-containing release agent coated thereon.

The working method according to the present invention includes the steps of applying a work piece and a support to one and to the other, respectively, of the thermally strippable pressure-sensitive adhesive layer 2 and the pressure-sensitive adhesive layer 3 of the thermally strippable double faced adhesive sheet according to the present invention (applying step); working the applied work piece (working step); and recovering the worked work piece by peeling through a heating treatment (recovering step).

The work piece for use herein includes, but is not limited to, electronic components such as ceramic capacitors; and semiconductor wafers. According to the method, the thermally strippable double faced adhesive sheet includes, as a substrate, a porous substrate, and this helps, even when applied to an adherend having large roughness on the surface facing the thermally strippable pressure-sensitive adhesive layer 2, to volumetrically mitigate and absorb the roughness. Accordingly, when a rigid support (hard substrate) is applied to the pressure-sensitive adhesive layer 3 of the thermally strippable double faced adhesive sheet, the pressure-sensitive adhesive layer maintains its surface flat without bearing a replica of the roughness, and the support can be applied thereto satisfactorily. After the support (hard substrate) is applied, therefore, the work piece is firmly supported by the hard substrate, and this enables working on the work piece without problems such as fracture and water intrusion. This exhibits significant advantages particularly when working (such as grinding) is carried out on the back side of a work piece having a maximum surface roughness amplitude of 10 µm or more (for example, from about 10 to about 150 µm, and preferably from about 15 to about 50 µm), such as a bumped semiconductor wafer and a semiconductor wafer having depressions formed typically as transistors.

The working is not particularly limited in its type and includes, for example, grinding, cutting, assembly, lamination, and firing. A heating treatment after the working can be carried out with a suitable heating device such as a hot plate, an air forced oven, a near-infrared ray lamp, or an air dryer. The heating temperature has only to be equal to or higher than the thermal expansion starting temperature (foaming starting temperature) of the blowing agent such as heat-expandable microspheres in the thermally strippable pressure-sensitive adhesive layer 2. Conditions for the heating treatment can be suitably set according typically to the thermal stability of the adherend and the heating procedure to be employed. The heating treatment is generally conducted under conditions at a temperature of from 100°C to 250°C for a duration of 1 to 90 seconds (typically using a hot plate) or for a duration of 1 to 15 minutes (typically using an air forced oven). Examples

The present invention will be illustrated in further detail with reference to several examples below. It should be noted, however, that these examples are never construed to limit the scope of the present invention.

### EXAMPLE 1

A UV (ultraviolet) reactive acrylic-urethane syrup B was prepared by incorporating 10 parts by weight of hollow glass beads (having an average particle diameter of 67 µm) into 100 parts by weight of a UV reactive acrylic-urethane syrup A composed of 50 parts by weight of a urethane polymer, 40 parts by weight of butyl acrylate, 10 parts by weight of acrylic acid, and 0.15 part by weight of a photoinitiator. The UV reactive acrylic-urethane syrup B was applied to a thickness of 400 µm to a PET (poly(ethylene terephthalate)) film 25 µm thick, dried, and irradiated with an ultraviolet ray, to give a porous film with a PET film having a total thickness of 325 µm. This includes the PET film, and arranged thereon, a porous substrate layer composed of an acrylic-urethane copolymer. Independently, a thermally strippable pressure-sensitive adhesive A was prepared by adding 3 parts by weight of an isocyanate crosslinking agent and 25 parts by weight of heat-expandable microspheres [trade name "Matsumoto Microsphere F-301SD", supplied by Matsumoto Yushi-Seiyaku Co., Ltd.] to 100 parts by weight of an acrylic polymer A composed of 100 parts by weight of butyl acrylate and 5 parts by weight of 2-hydroxyethyl acrylate; and the thermally strippable pressure-sensitive adhesive A was applied to a PET separator and the applied film was dried to give a thermally strippable pressure-sensitive adhesive layer 25 µm thick. This was transferred onto the naked surface of the porous substrate. Further independently, an acrylic pressure-sensitive adhesive B was prepared by adding 0.5 part by weight of an epoxy crosslinking agent to 100 parts by weight of an acrylic polymer B composed of 50 parts by weight of butyl acrylate, 50 parts by weight of ethyl acrylate, and 3.5 parts by weight of acrylic acid; and the acrylic pressure-sensitive adhesive B was applied to a PET separator, and the applied film was dried to give a layer 20 µm thick. This was transferred to the surface of the PET film on the porous substrate, to give a thermally strippable double faced adhesive sheet A.

### EXAMPLE 2

A heat-expandable pressure-sensitive adhesive was prepared by adding 2.5 parts by weight of an isocyanate crosslinking agent [trade name "CORONATE L", supplied by Nippon Polyurethane Industry Co., Ltd.] and 40 parts by weight of heat-expandable microspheres [trade name "Matsumoto Microsphere F-80VSD", supplied by Matsumoto Yushi-Seiyaku Co., Ltd.] to 100 parts by weight of an acrylic polymer composed of 100 parts by weight of butyl acrylate and 4 parts by weight of acrylic acid; and the heat-expandable pressure-sensitive adhesive was applied to a PET (poly(ethylene terephthalate)) film 50 µm thick, and subjected to a heating process at 160°C to allow the heat-expandable microspheres to expand, to give a porous film with a PET film, having a thickness of 170 µm. This includes a PET film, and arranged thereon, a porous substrate layer composed of an acrylic copolymer. Thereafter, a thermally strippable double faced adhesive sheet B was prepared in the same way as in Example 1.

### COMPARATIVE EXAMPLE 1

A thermally strippable double faced adhesive sheet C was prepared by the procedure of Example 1, except for not using hollow glass beads. The substrate herein has a layer structure including a PET film, and arranged thereon, a non-porous substrate layer composed of an acrylic-urethane copolymer.

### COMPARATIVE EXAMPLE 2

A thermally strippable double faced adhesive sheet was prepared by the procedure of Example 1, except for using a PET film 250 µm thick as the substrate.

### Evaluation Tests

The thermally strippable pressure-sensitive adhesive layer of each of the thermally strippable double faced adhesive sheets prepared according to Examples and Comparative Examples was applied to a full-array bumped wafer (having a maximum surface roughness amplitude of 40 µm) of a chip size 10 mm wide and 10 mm long, a bump height 40 µm, a bump pitch 130 µm, and a wafer thickness 725 µm; a glass wafer (support) having the same diameter with that of the bumped wafer was applied to the back-side pressure-sensitive adhesive layer; and whether and how the glass wafer lifted was visually observed. The back side of the bumped wafer was then ground to a thickness of 75 µm, and whether or not wafer cracking occurred was visually observed. Ultimately, after subjecting a heating treatment (heating in an air forced oven at 120°C for 3 minutes), how the bumped wafer was thermally stable was examined. Herein, the lamination between the thermally strippable double faced adhesive sheet and the bumped wafer was conducted with a device under the trade name "DR3000 II-WS" [supplied by Nitto Seiki Co., Ltd.]; the lamination of the glass wafer was conducted with a device under the trade name "MA-3000 II-WS" [supplied by Nitto Seiki Co., Ltd.]; and the wafer grinding was conducted with a device under the trade name "DFG-8460" [supplied by DISCO Corporation]. The results are shown in Table 1.

The bump height and wafer thickness were directly measured with a 1/1000-mm dial gauge, and the bump pitch was measured with a digital microscope. The density of the porous substrate (layer) [or, for Comparative Example 1, of the non-porous substrate (layer) composed of an acrylic-urethane copolymer] was determined by measuring the size (length and width), thickness, and weight of a sample with a steel gauge, a dial gauge having a resolution of 1/1000 mm, and a digital gravimeter having a resolution of 1/1000g, respectively, in an atmosphere at room temperature (23°C) and humidity of 50%; and determining the density by dividing the weight by the volume. As the tensile elastic modulus, an initial elastic modulus was read from a stress-strain curve which was plotted with a tensile load measuring device.

### [Table 1]

**TABLE 1**

| | | Example 1 | Example 2 | Com. Ex. 1 | Com. Ex. 2 |
|---|---|---|---|---|---|
| Porous substrate | Density (g/cm³) | 0.69 | 0.44 | (1.08) | - |
| | Tensile elastic modulus (MPa) | 2.3 | 5.1 | (2.0) | - |
| Lifting after lamination of glass wafer (support) | | none | none | lifting around periphery | lifting around periphery and scribe line |
| Condition of bumped wafer after grinding | | good | good | cracking and water intrusion occurs around periphery | cracking and water intrusion occurs inside and around periphery of wafer |
| Peelability through heating | | good | good | good | good |

### Industrial Applicability

According to the present invention, there are provided a thermally strippable double faced adhesive sheet; and a method of working a work piece using the thermally strippable double faced adhesive sheet. More specifically, the thermally strippable double faced adhesive sheet can immediately reduce its adhesive strength through a heating treatment and is suitably used in the working of a work piece with large surface roughness. A work piece is worked by the method using the thermally strippable double faced adhesive sheet.

## Claims

1. A thermally strippable double faced adhesive sheet comprising a substrate, a thermally strippable pressure-sensitive adhesive layer (A) arranged on one side of the substrate, and a pressure-sensitive adhesive layer (B) arranged on the other side of the substrate, wherein the substrate comprises a porous substrate.

2. The thermally strippable double faced adhesive sheet according to claim 1, wherein the porous substrate has a density of 0.9 g/cm³ or less and a tensile elastic modulus of 20 MPa or less.

3. The thermally strippable double faced adhesive sheet according to one of claims 1 and 2, wherein the substrate comprises a laminate of the porous substrate and a non-porous substrate.

4. The thermally strippable double faced adhesive sheet according to any one of claims 1 to 3, wherein the pressure-sensitive adhesive layer (B) includes an adhesive selected from the group consisting of pressure-sensitive adhesives, ultraviolet-curable pressure-sensitive adhesives, thermally strippable pressure-sensitive adhesives, thermoplastic pressure-sensitive adhesives, and thermosetting pressure-sensitive adhesives.

5. A method of working a work piece, the method comprising the steps of: applying a work piece and a support to one and to the other, respectively, of the thermally strippable pressure-sensitive adhesive layer (A) and the pressure-sensitive adhesive layer (B) of the thermally strippable double faced adhesive sheet of any one of claims 1 to 4; working the applied work piece; and recovering the worked work piece by peeling through a heating treatment.

6. The method of working a work piece, according to claim 5, wherein the work piece is an electronic component or semiconductor wafer.

7. The method of working a work piece, according to one of claims 5 and 6, wherein the work piece has a side with a maximum surface roughness amplitude of 10 µm or more, the side of the work piece is applied to an adhesive face of the thermally strippable double faced adhesive sheet, and the applied work piece is worked.
